# EUROPEAN PATENT SPECIFICATION

(11) **EP 2 988 321 B1**
(45) Date of publication and mention of the grant of the patent: **20.03.2019**
(21) Application number: 14784903.8
(22) Date of filing: 07.04.2014
(51) Int. Cl.: C11D 3/28, C11D 3/30, C11D 3/32, C11D 3/33, C11D 7/32, H01L 21/02

(54) **CLEANING LIQUID COMPOSITION**
REINIGUNGSFLÜSSIGKEITSZUSAMMENSETZUNG
COMPOSITION DE LIQUIDE NETTOYANT

(30) Priority: 19.04.2013 JP 2013088637
(43) Date of publication of application: 24.02.2016
(73) Proprietor: Kanto Kagaku Kabushiki Kaisha, Tokyo, 103-0023 (JP)
(72) Inventor: MORITA, Kikue, Soka-shi Saitama 340-0003 (JP); HORIKE, Chiyoko, Soka-shi Saitama 340-0003 (JP); FUKAYA, Keisuke, Soka-shi Saitama 340-0003 (JP); OHWADA, Takuo, Soka-shi Saitama 340-0003 (JP)
(74) Representative: Zech, Stefan Markus
(86) International application number: PCT/JP2014/060060
(87) International publication number: WO 2014/171355

(56) References cited:
- EP-A1- 1 577 934
- WO-A1-2005/085408
- WO-A1-2006/127885
- WO-A1-2008/023214
- WO-A2-2008/085408
- WO-A2-2011/094568
- JP-A- 2005 307 187

## Description

### [Technical Field]

The present invention relates to a cleaning liquid composition used for cleaning a substrate having Cu wiring, a method for producing a semiconductor substrate using the cleaning liquid composition, and a method for dissolving Cu-containing organic residue using the cleaning liquid composition.

### [Background Art]

Accompanying the increasing integration of ICs, since contamination with a trace amount of an impurity affects the performance and yield of a device, strict contamination control is required. That is, there is a demand for strict control of contamination of a substrate, and various types of cleaning liquids are used in various steps of semiconductor substrate fabrication.

In general, as a substrate cleaning liquid for a semiconductor substrate, in order to remove particulate contamination ammonia-aqueous hydrogen peroxide-water (SC-1), which is an alkaline cleaning liquid, is used, and in order to remove metal contamination sulfuric acid-aqueous hydrogen peroxide, hydrochloric acid-aqueous hydrogen peroxide-water (SC-2), dilute hydrofluoric acid, etc., which are acidic cleaning liquids, are used; the cleaning liquids are used singly or in combination according to the intended application.

On the other hand, accompanying progress in the increase in fineness and the multilayer wiring structure of devices, in each step more elaborate planarization of a substrate surface is required; as new techniques, chemical mechanical polishing (CMP) techniques have been introduced into the semiconductor substrate production process, in which polishing and planarization of an insulating film or a metal material is carried out by pressing a wafer against a polishing cloth called a buff while supplying a slurry mixture of polishing particles and a chemical agent, and rotating so as to effect a chemical action and a physical action in combination.

In particular, in a state-of-the-art device employing Cu, which has a lower wiring resistance than conventional Al, Cu wiring is formed by a damascene process. The damascene process is a process in which a wiring pattern is formed in an interlayer insulating film as a trench, Cu is embedded using sputtering or electro-plating, and unwanted blanket Cu is then removed by chemical mechanical polishing, etc., thus forming a wiring pattern.

The substrate surface after CMP is contaminated by particles represented by alumina, silica, or cerium oxide particles contained in the slurry, the substance constituting the surface to be polished, or metallic impurities originating from the agent contained in the slurry. It is necessary to completely remove these contaminants before entering a subsequent step since they cause pattern defects, adhesion failure, improper electrical properties, etc. As normal post-CMP cleaning in order to remove these contaminants, brush cleaning is carried out, in which a chemical action due to a cleaning liquid and a physical action due to a polyvinyl alcohol sponge brush, etc. are used in combination. As the cleaning liquid, conventionally, an alkali such as ammonia has been used for the removal of particles. Furthermore, a technique employing an organic acid and a complexing agent for the removal of metal contamination has been proposed in Patent Document 1 and Patent Document 2.

Moreover, as a technique for removing metal contamination and particulate contamination at the same time, a cleaning liquid employing an organic acid and a surfactant in combination has been proposed in Patent Document 3. However, accompanying progress in the increase in fineness of wiring patterns of semiconductor devices, corrosion of Cu during post-CMP cleaning has to be taken into consideration, and an acidic cleaning liquid has the problem of an increase in the roughness of the surface. On the other hand, a basic cleaning liquid damages a low permittivity (low-k) interlayer insulating film material, which has been introduced accompanying the increase in fineness of wiring.

Patent Document 5 discloses a post-CMP semiconductor surface cleaning solution containing a carboxylic acid, an amine-containing compound, and phosphonic acid, and Patent Document 6 discloses a semiconductor wafer treatment liquid containing an alkali component and an adsorption prevention agent, but in none thereof has an investigation been carried out into a substrate having Cu wiring.

JP 2005/307187 a discloses a post-CMP cleaning composition for cleaning semiconductors with copper wiring, comprising an organic base tetramethylammoniumhydroxyide as a basic compound and an amino polycarboxylic acid and a hydroxycarboxylic acid. In the Examples of JP 2005/307187 tetramethylammoniumhydroxyide is used as the representative of the organic base while EDTA is used as the amino polycarboxylic acid in admixture with gluconic acid and citric acid as hydroxycarboxylic acids.

As a composition for cleaning a substrate having Cu wiring, Patent Document 7 discloses a formulation containing a sulfonic acid-based polymer, Patent Document 8 discloses a cleaning composition containing a porous dielectric, a corrosion inhibiting solvent compound, an organic co-solvent, a metal chelating agent, and water, and Patent Document 9 discloses a cleaning liquid containing a chelating agent or a salt thereof, an alkali metal hydroxide, and water; in none of the compositions has an investigation into damage to a low-k material or an investigation into the removal of both particulates and metallic impurities been carried out. Patent Document 10 discloses a cleaning liquid containing an deactivator that deactivates the surface of a low-k material, but it requires a step of removing a deactivated film formed by said deactivator.

In a damascene process for forming Cu wiring, an organic corrosion inhibitor for the purpose of controlling the Cu polishing rate is added to a CMP slurry. As the organic corrosion inhibitor, benzotriazole (BTA) is mainly used; these organic corrosion inhibitors react with Cu during the CMP process and are crosslinked via Cu to become dimers or oligomers, thus remaining on the substrate surface as an insoluble organic residue. In recent years, the removability for the organic residue caused by Cu is an important property required for a post-CMP cleaning liquid, and the biggest problem of the current cleaning liquids cited in the references above is insufficient removability. As a composition for removing the organic residue caused by Cu, Patent Document 11 discloses a cleaning liquid containing an amine and a guanidine salt or a guanidine derivative salt, Patent Document 12 discloses a cleaning liquid containing an aliphatic amine, gallic acid, a quaternary ammonium hydroxide, and ascorbic acid, Patent Document 13 discloses a cleaning liquid containing a cyclic amine, gallic acid, a quaternary ammonium hydroxide, and ascorbic acid, Patent Document 14 discloses a cleaning liquid containing hydrazine and an organic solvent, Patent Documents 15 and 16 disclose a cleaning liquid containing an organic amine and a polyhydric hydroxy group-containing compound, and Patent Document 17 discloses a cleaning liquid containing an organic amine, a quaternary ammonium compound, and a urea group- or thiourea group-containing compound, but a guanidine or a urea group-containing compound and a polyhydric hydroxy group-containing compound have insufficient removability for an organic residue, and ascorbic acid not only has no effect on organic residue removability but also degrades metallic impurity removability.

Furthermore, for the purpose of suppressing corrosion of Cu in a cleaning liquid, Patent Document 18 discloses a cleaning liquid containing an alcoholamine, piperazine, and a piperazine derivative, but the corrosion prevention is not sufficient. Moreover, Patent Document 19 discloses a cleaning liquid containing a quaternary ammonium hydroxide and a carboxybenzotriazole and, for the purpose of suppressing corrosion of Cu in a residue removing liquid after dry etching or after a removal treatment, Patent Document 20 discloses an aqueous solution containing a purine derivative; these compounds have a high proportion of hydrophobic moieties within the molecular structure and adsorb on the Cu surface after treatment, thus becoming a new organic residue. Furthermore, Patent Document 21 discloses a cleaning liquid containing a basic organic compound, an acidic organic compound, and imidazole and is adjusted so as to be substantially neutral, but the liquid cannot remove an organic residue that has become attached during a CMP process since the liquid is neutral.

As described above, there has until now been no known cleaning liquid composition that has excellent removability for impurities such as metallic impurities, particles, and organic residue that have become attached to a wafer surface after CMP, in particular an organic residue, and that is free from problems with Cu corrosion and damage to a low permittivity interlayer insulating film.

### [Prior Art Documents]

### [Patent Documents]

[Patent Document 1] JP, A, 10-072594
[Patent Document 2] JP, A, 11-131093
[Patent Document 3] JP, A, 2001-7071
[Patent Document 4] JP, A, 11-116984
[Patent Document 5] JP, A (PCT) 2003-510840
[Patent Document 6] JP, A, 06-041773
[Patent Document 7] JP, A, 2011-040722
[Patent Document 8] JP, A, 2009-081445
[Patent Document 9] International Patent Application WO 2004/042811
[Patent Document 10] JP, A (PCT) 2008-543060

[Patent Document 11] JP, A, 2012-021151
[Patent Document 12] JP, A, 2012-186470
[Patent Document 13] JP, A, 2011-205011 (also published as WO 2011/094568 A2)
[Patent Document 14] JP, A (PCT) 2012-516046
[Patent Document 15] JP, A, 2009-194049
[Patent Document 16] JP, A, 2009-239206
[Patent Document 17] JP, A, 2011-074189
[Patent Document 18] JP, A, 2007-002227
[Patent Document 19] JP, A, 2001-107098
[Patent Document 20] JP, A, 2002-097584
[Patent Document 21] JP, A, 2012-046685

### [Summary of the Invention]

### [Problems to be Solved by the Invention]

It is therefore an object of the present invention to provide a cleaning liquid composition that has excellent removability for impurities such as metallic impurities, particulates, and organic residue as a reaction product between Cu and an organic corrosion inhibitor, in particular organic residue, that does not cause corrosion of a metal material such as Cu, and that can suppress further oxidation by protecting a cleaned Cu surface with a thin oxide film layer in cleaning of a metal material surface of a substrate that has been subjected to a polishing treatment, an etching treatment, a chemical mechanical polishing (CMP) treatment, etc. in a production process of an electronic device such as a semiconductor device. It is another object of the present invention to provide a cleaning liquid composition that is not only for cleaning a substrate but can also be used for dissolution of a Cu-containing organic residue in all applications, and a method for dissolving an organic residue using said cleaning liquid composition.

### [Means for Solving the Problems]

While carrying out an intensive investigation in order to solve the above-mentioned problems the present inventors have found that a cleaning liquid composition comprising one or more types of basic compound and one or more types of nitrogen atom-containing heteromonocyclic aromatic compound as identified in claim 1, and having a hydrogen ion concentration (pH) of 8 to 11 which does not contain isoascorbic acid, ascorbic acid or gallic acid, has high removability for metallic impurities and particulates, in particular organic residue, does not cause corrosion of a metal material such as Cu, and can suppress further oxidation by protecting the cleaned Cu surface by means of a thin oxide film, and as a result of further research, the present invention has been accomplished.

That is, the present invention relates to the following.
[1] A cleaning liquid composition for cleaning a substrate having Cu wiring, the cleaning liquid composition comprising one or more types of basic compound and one or more types of nitrogen atom-containing heteromonocyclic aromatic compound as identified in claim 1, and having a hydrogen ion concentration (pH) of 8 to 11, wherein the composition does not contain isoascorbic acid, ascorbic acid or gallic acid.
[2] The cleaning liquid composition according to [1], wherein the substrate having Cu wiring is a substrate obtained after chemical mechanical polishing (CMP).
[3] The cleaning liquid composition according to [1] or [2], wherein the nitrogen atom-containing heteromonocyclic aromatic compound is a five-membered ring compound.
[4] The cleaning liquid composition according to any one of [1] to [3], wherein the basic compound is a quaternary ammonium compound or a straight chain aliphatic amine.
[5] The cleaning liquid composition according to any one of [1] to [4], wherein the basic compound is a quaternary ammonium compound other than tetramethylammonium hydroxide, or an alkanolamine.
[6] The cleaning liquid composition according to any one of [1] to [5], wherein it comprises one or more types of phosphonic acid-based chelating agent.
[7] The cleaning liquid composition according to [6], wherein the phosphonic acid-based chelating agent is one or more types selected from the group consisting of *N,N,N',N'-*ethylenediaminetetrakis(methylenephosphonic acid) (EDTPO), glycine-*N,N*-bis(methylenephosphonic acid) (glyphosine), nitrilotris(methylenephosphonic acid) (NTMP), and salts thereof.
[8] The cleaning liquid composition according to any one of [1] to [7], wherein it further comprises one or more types of anionic or nonionic surfactant.
[9] A starting solution composition for the cleaning liquid composition according to any one of [1] to [8], the starting solution composition being for use in obtaining the cleaning liquid composition by dilution at 10 times to 1000 times.
[10] A method for producing a semiconductor substrate, comprising a step of putting a substrate having Cu wiring in contact with the cleaning liquid composition according to any one of [1] to [8].
[11] The method for producing a semiconductor substrate according to [10], wherein it comprises a step of subjecting the substrate having Cu wiring to chemical mechanical polishing (CMP) prior to the step of putting a substrate having Cu wiring in contact.
[12] The method for producing a semiconductor substrate according to [10] or [11], wherein the step of putting a substrate having Cu wiring in contact is a step of cleaning the substrate having Cu wiring.
[13] A method for dissolving a Cu-containing organic residue, the method comprising a step of putting a Cu-containing organic residue in contact with a cleaning liquid composition comprising one or more types of basic compound and one or more types of nitrogen atom-containing heteromonocyclic aromatic compound as identified in claim 13, and having a hydrogen ion concentration (pH) of 8 to 11, wherein the composition does not contain isoascorbic acid, ascorbic acid or gallic acid.
[14] The method according to [13], wherein the Cu-containing organic residue comprises a Cu-benzotriazole (BTA) complex.

### [Effects of the Invention]

The cleaning liquid composition of the present invention has excellent removability for metallic impurities, particulates, in particular a Cu-containing organic residue, which is a product of a reaction between Cu and an organic corrosion inhibitor, does not cause corrosion of a metal material such as Cu, and can suppress further oxidation by protecting a cleaned Cu surface with a thin oxide film layer in cleaning of a metal material surface of a substrate that has been subjected to a polishing treatment, an etching treatment, a chemical mechanical polishing (CMP) treatment, etc. in a production process of an electronic device such as a semiconductor device. Furthermore, the cleaning liquid composition of the present invention can be used not only for cleaning of a substrate but also for dissolution of a Cu-containing organic residue in all applications.

### [Brief Description of Drawings]

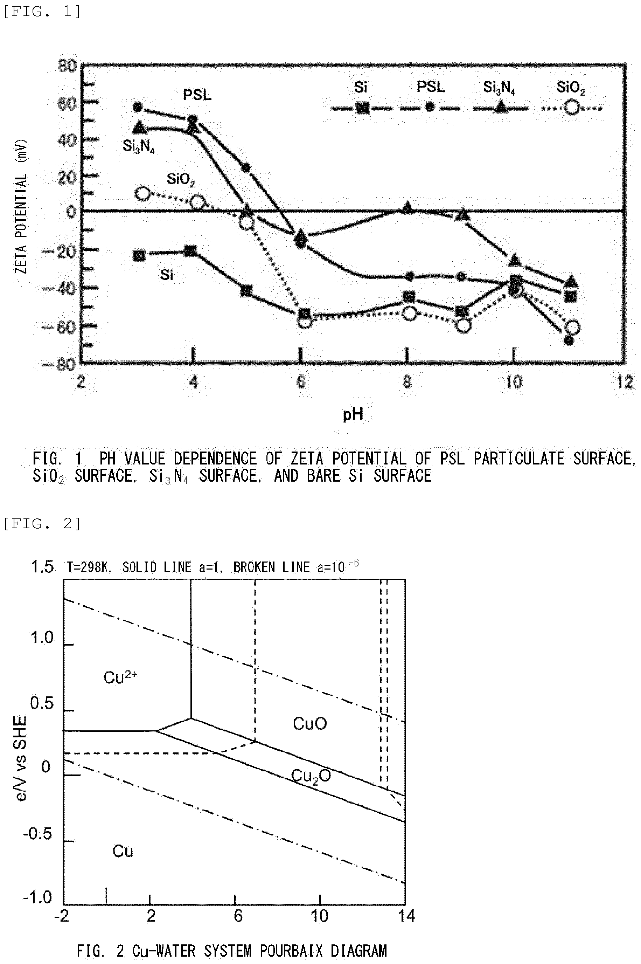

FIG. 1 is a diagram showing the pH dependence of the zeta potential of a PSL (polystyrene latex) particulate surface, SiO₂ surface, Si₃N₄ surface, and a bare Si surface (THE CHEMICAL TIMES, 2005, No.4, p.6).
FIG. 2 is a Pourbaix diagram of a Cu-water system.
FIG. 3 is a Pourbaix diagram of a Cu-BTA-water system.
FIG. 4 is an IR spectrum of Example 29 (Abs: absorbance, Initial: initial value, 3 min: for 3 minutes, 30 min: for 30 minutes, Wavenumber: wavenumber).
FIG. 5 is an IR spectrum of Example 30 (Abs: absorbance, Initial: initial value, 3 min: for 3 minutes, 30 min: for 30 minutes, Wavenumber: wavenumber).

### Modes for Carrying Out the Invention

The present invention is explained below in detail by reference to preferred embodiments of the present invention.

First, the cleaning liquid composition and the starting solution composition of the present invention are explained.

The cleaning liquid composition of the present invention is a cleaning liquid composition for cleaning a substrate having Cu wiring.

The cleaning liquid composition of the present invention contains one or more types of basic compound and one or more types of nitrogen atom-containing heteromonocyclic aromatic compound as specified in claim 1, has a hydrogen ion concentration (pH) of 8 to 11, and does not contain isoascorbic acid, ascorbic acid or gallic acid.

The basic compound used in the present invention is not particularly limited as long as it can carry out adjustment to give a predetermined pH.

When the cleaning liquid composition of the invention of the present application is used for an electronic device, etc. in particular, the basic compound is preferably a basic compound that does not contain a metal ion. As one of the reasons therefor, when the basic compound contains a metal ion, back contamination and diffusion into the interior of a substrate occur, thus causing an increase in leakage current due to poor insulation of an interlayer insulating film or causing degradation of semiconductor properties. Furthermore, when the basic compound does not contain a metal ion, there is the advantage that in fabrication of a circuit substrate the resistivity can be more strictly controlled.

The content of the basic compound is not particularly limited since it has a role in adjusting the pH, which varies according to the type of said basic compound and the type and content of other components, but the content when used is preferably 0.5 to 50 mmol/L, particularly preferably 0.5 to 30 mmol/L, and more particularly preferably 0.5 to 20 mmol/L. When the content of said basic compound is lower than such a range, there is a possibility that the pH will change due to slight variation of the composition or contamination with an impurity, and when the content of said basic compound is higher than such a range, there is a possibility that damage to a low-k material will increase.

Examples of the basic compound include, but are not limited to, a quaternary ammonium compound and an amine.

Specific examples of the quaternary ammonium compound include, but are not limited to, tetramethylammonium hydroxide (TMAH), trimethyl-2-hydroxyethylammonium hydroxide (choline), tetraethylammonium hydroxide, tetrapropylammonium hydroxide, tetrabutylammonium hydroxide, trimethylphenylammonium hydroxide, and benzyltrimethylammonium hydroxide. Choline and tetraethylammonium hydroxide are preferable, and choline and tetraethylammonium hydroxide are more preferable.

In one embodiment, the cleaning liquid composition of the present invention does not contain tetramethylammonium hydroxide (TMAH), which is a quaternary ammonium compound. Among quaternary ammonium compounds tetramethylammonium hydroxide has high toxicity, manufacturers who are concerned about its effect on workers in a production process have recently tended to avoid it, and it is therefore preferable as far as possible for it not to be contained.

With regard to the amine, from the viewpoint of the number of nitrogen atoms present in the molecule of the amine, there are monoamines, which contain one nitrogen atom, diamines, which contain two nitrogen atoms, triamines, which contain three nitrogen atoms, and polyamines, which contain more than three nitrogen atoms. Furthermore, with regard to the amine, from the viewpoint of the number of hydrogen atoms of ammonia (NH₃) that have been replaced by a hydrocarbon group, which may have a substituent, there are primary amines, secondary amines, and tertiary amines.

Examples of these amines include, but are not limited to, primary aliphatic amines, secondary aliphatic amines, tertiary aliphatic amines, alicyclic amines, aromatic amines, and heterocyclic amines. Among them, from the viewpoint of being readily available and curbing the cost of raw materials, primary aliphatic amines, secondary aliphatic amines, tertiary aliphatic amines, and heterocyclic amines are preferable, and primary aliphatic amines, secondary aliphatic amines, and tertiary aliphatic amines are more preferable. Furthermore, the amines also include alkanolamines, diamines, etc.

Examples of the primary aliphatic amine, the secondary aliphatic amine, and the tertiary aliphatic amine include, but are not limited to, an alkylamine, an alkanolamine, a diamine, and a triamine.

Examples of the primary aliphatic amine include, but are not limited to, ones that have 1 to 10 carbons and that may be straight chain or branched; specific examples include monoethanolamine, ethylenediamine, 2-(2-aminoethoxy)ethanol-, 2-(2-aminoethylamino)ethanol, diethylenetriamine, and triethylenetetramine. Among them, from the viewpoint of being readily available and curbing the cost of raw materials, it is preferably monoethanolamine, 2-(2-aminoethoxy)ethanol-, or 2-(2-aminoethylamino) ethanol.

Examples of the secondary aliphatic amine include, but are not limited to, ones that have 1 to 10 carbons and that may be straight chain or branched; specific examples include diethanolamine, *N*-methylaminoethanol, *N-*hydroxyethylaminoethanol, dipropylamine, and 2-ethylaminoethanol. Among them, from the viewpoint of being readily available and curbing the cost of raw materials, it is preferably diethanolamine or *N*-methylaminoethanol.

Examples of the tertiary aliphatic amine include, but are not limited to, ones that have 1 to 10 carbons and that may be straight chain or branched; specific examples include triethanolamine, dimethylaminoethanol, and ethyldiethanolamine. Among them, from the viewpoint of being readily available and curbing the cost of raw materials, it is preferably triethanolamine.

Examples of the alicyclic amine include, but are not limited to, ones that have 3 to 10 carbons, and specific examples include cyclopentylamine and cyclohexylamine etc.. Among them, from the viewpoint of being readily available and curbing the cost of raw materials, it is preferably cyclohexylamine.

Examples of the aromatic amine include, but are not limited to, ones that have 6 to 10 carbons, and specific examples include aniline and 4-aminophenol etc.. Among them, from the viewpoint of being readily available and curbing the cost of raw materials, it is preferably 4-aminophenol.

Examples of the heterocyclic amine include, but are not limited to, ones that have 4 to 10 carbons, and specific examples include piperidine, piperazine, *N-*aminoethylpiperazine, *N*-hydroxyethylpiperazine, *N*-methyl-*N'-*hydroxyethylpiperazine, *N*-aminoethylpiperazine, *N,N'-*dimethylaminoethylmethylpiperazine, 1-(2-dimethylaminoethyl)-4-methylpiperazine, morpholine, *N*-methylmorpholine, *N-*hydroxyethylmorpholine, and *N*-aminoethylmorpholine etc.. Among them, from the viewpoint of being readily available and curbing the cost of raw materials, it is preferably morpholine, piperidine, piperazine, *N*-aminohydroxyethylpiperazine, *N-*aminoethylpiperazine, or 1-(2-dimethylaminoethyl)-4-methylpiperazine.

The basic compound might damage a low-k material depending on the molecular structure of the basic compound. When a primary amine in particular is used, there are many cases in which a low-k material is damaged. Because of this, the basic compound is preferably a secondary amine, a tertiary amine, or a quaternary ammonium compound.

Furthermore, among the amines, since some of the alicyclic amines, aromatic amines, and heterocyclic amines, which have a cyclic structure in the molecule, might strongly adsorb on a Cu surface and become a contaminant, a straight chain aliphatic amine is preferable. Furthermore, examples of the straight chain aliphatic amine include, but are not limited to, an alkanolamine, a diamine, a triamine, and a tetramine etc.. Among them, from the viewpoint of being readily available and curbing the cost of raw materials, it is preferably an alkanolamine.

Moreover, some of the primary amines and secondary amines tend to have a high Cu complex stability constant, form a water-soluble complex, and thus dissolve Cu. Therefore, from this viewpoint the amine is preferably an alkanolamine having 1 to 10 carbons, more preferably diethanolamine, which is a secondary aliphatic amine, or triethanolamine, which is a tertiary aliphatic amine, and particularly preferably triethanolamine.

The content of the nitrogen atom-containing heteromonocyclic aromatic compound is not particularly limited since it varies according to the type of nitrogen atom-containing heteromonocyclic aromatic compound and the type and content of other components, but the content when used is preferably 0.1 to 10 mmol/L, particularly preferably 0.1 to 5 mmol/L, and more particularly preferably 0.1 to 2 mmol/L. When the content of the heteromonocyclic aromatic compound is lower than such a range, the removability for an organic residue is low, and when the content of the heteromonocyclic aromatic compound is higher than such a range, there is a possibility that damage to Cu will increase.

Among the nitrogen atom-containing heteromonocyclic aromatic compounds, examples of five-membered ring compounds include, pyrrole, pyrazole, oxazole, isoxazole, and derivatives thereof, and specific examples include 1H-pyrrole, minaline, 1H-pyrazole, 1H-pyrazole-4-carboxylic acid, 1-methyl-1H-pyrazole-5-carboxylic acid, 5-methyl-1H-pyrazole-3-carboxylic acid, 3,5-pyrazole dicarboxylic acid, 3-amino-5-hydroxypyrazole, histidine, histamine, 3-amino-1,2,4-triazole, 4-amino-1,2,4-triazole, and 3,5-diamino-1,2,4-triazole. Among them, from the viewpoint of being industrially readily available and having high water solubility, pyrazole, 3,5-pyrazole dicarboxylic acid, 3-amino-5-hydroxypyrazole, 3,5-diamino-1,2,4-triazole, histidine, and histamine are preferable, and histidine, histamine, and 3,5-diamino-1,2,4-triazole are particularly preferable.

Among the nitrogen atom-containing heteromonocyclic aromatic compounds, examples of six-membered ring compounds include pyridine, pyrazine, pyrimidine, pyridazine, and derivatives thereof, and specific examples include pyridine, 2-pyridone, 4-pyridone, picoline, α-collidine, β-collidine, γ-collidine, picolinic acid, picolinamide, nicotinic acid, nicotinamide, isonicotinic acid, citrazinic acid, quinolinic acid, lutidinic acid, isocinchomeronic acid, dipicolinic acid, cinchomeronic acid, dinicotinic acid, berberonic acid, fusaric acid, ethionamide, nicotine, cotinine, anabasine, anatabine, homarine, trigonelline, picolinuric acid, nicotinuric acid, risedronic acid, dihydroxypyridine, pyrazine, pyrazinoic acid, pyrazinamide, pyrimidine, cytosine, uracil, thymine, orotic acid, dialuric acid, uramil, isouramil, thiamine, pyridazine, maleic acid hydrazide, melamine, and cyanuric acid. Among them, from the viewpoint of being industrially readily available and having high water solubility, cytosine and cyanuric acid are preferable.

The cleaning liquid composition of the present invention contains a nitrogen atom-containing heteromonocyclic aromatic compound. The heteromonocyclic aromatic compound is added in order to remove organic residue on the substrate surface.

Examples of the organic residue include, but are not limited to, a Cu-containing organic residue, which is a dimer or oligomer of an organometallic complex that is formed by crosslinking with Cu as a result of a reaction between Cu and an organic corrosion inhibitor such as benzotriazole (BTA) during a CMP process, the Cu-containing organic residue being insoluble. In order to dissolve this Cu-containing organic residue in the cleaning liquid, there is a method in which coordination bonding between Cu and an organic corrosion inhibitor is cleaved by changing the pH of the cleaning liquid to thus decrease the molecular weight.

Among Cu-containing organic residues, examples of the dimer or oligomer of an organometallic complex formed by crosslinking with Cu by a reaction between Cu and an organic corrosion inhibitor such as benzotriazole (BTA) during a CMP process include, but are not limited to, a Cu-benzotriazole (BTA) complex.

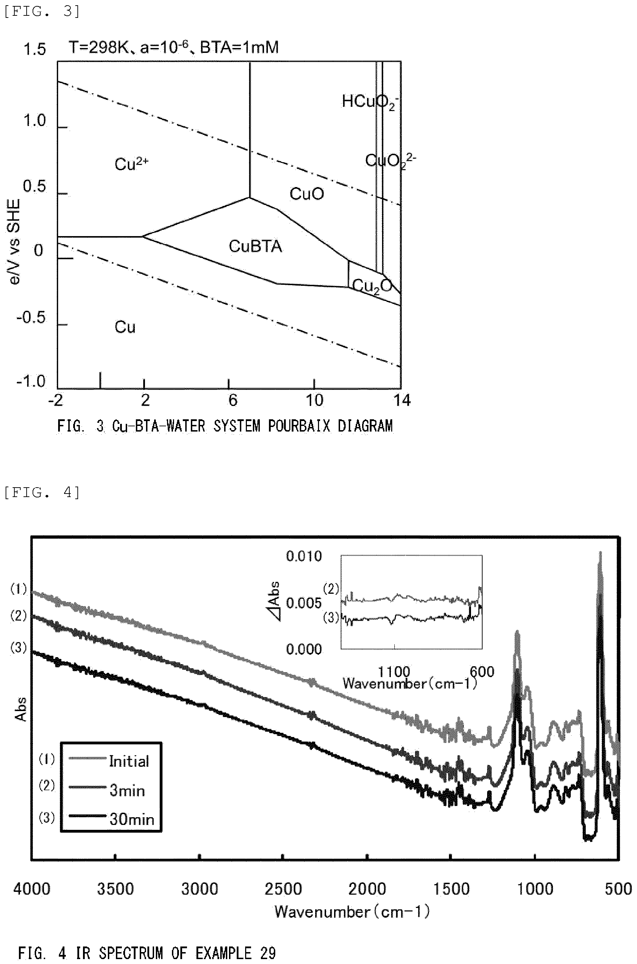

The Cu-BTA complex referred to here means a complex formed by crosslinking etc. between Cu and benzotriazole (BTA), , and examples include, but are not limited to, a Cu-BTA complex and a compound formed by mixing a Cu-BTA complex and a slurry-derived inorganic substance such as SiO₂. This Cu-BTA complex cannot maintain its complex stably when the pH is equal to or less than 2 or equal to or greater than 11, and turns into low molecular weight substances that dissolve in the cleaning liquid (see FIG. 3). However, as described above, when the pH is equal to or less than 2, Cu might be corroded or metallic Cu might be exposed after treatment, resulting in oxidation progressing in the air to a great extent; when the pH is greater than 11, there is a possibility of damage to a low-k material, and removal of an organic residue by changing the pH cannot be carried out. Because of this, by adding a complexing agent that has a higher complex stability constant than that between Cu and BTA, has a relatively small hydrophobic moiety in the molecule, and has high water solubility and by newly forming an organometallic complex between Cu and the complexing agent it is possible to remove an organic residue such as a Cu-BTA complex in a pH region of 8 to 11.

Since this new organometallic complex between Cu and the complexing agent has a smaller proportion of hydrophobic moiety compared with the Cu-BTA complex, it dissolves in the cleaning liquid. As this complexing agent, a nitrogen atom-containing heteromonocyclic aromatic compound is used. The nitrogen atom-containing heteromonocyclic aromatic compound is a five-membered ring compound or a six-membered ring compound. With regard to four- or fewer-membered ring compounds, since there are few compounds that are industrially produced at low cost, it is difficult to use them due to possible problems of increase in cost of raw materials and stability of product quality; with regard to seven- or higher-membered ring compounds, their solubility in water is low, even if they dissolve they are often unstable in an aqueous solution, there are also few compounds that are industrially produced at low cost as for the four- or fewer-membered ring compounds, and it is difficult to use them due to possible problems of increase in cost of raw materials and stability of product quality.

In the present invention, the pH of the cleaning liquid composition is 8 to 11, and preferably 9 to 11.

The substrate having Cu wiring in the present invention is not limited as long as it is a substrate obtained after chemical mechanical polishing (CMP), and examples include a substrate immediately after CMP and a substrate in which an insulating film in an upper layer has just been processed by dry etching after formation of Cu wiring. Among them, a substrate immediately after CMP is preferable.

Examples of Cu wiring in the present invention include, but are not limited to, Cu metal wiring, Cu alloy wiring, and layer wiring of Cu, a Cu alloy, and another metal film.

Chemical mechanical polishing (CMP) in the present invention may be carried out in accordance with known chemical mechanical polishing, and examples thereof include, but are not limited to, a method involving polishing with abrasive grains of SiO₂, Al₂O₃, etc. and a method involving polishing without abrasive grains but using an aqueous electrolyte. Among them, a method involving polishing with abrasive grains of SiO₂, Al₂O₃, etc. is preferable.

One of the important features of the cleaning liquid composition of the present invention is that particulates can be removed without using a surfactant. This is because in a basic region the surface of an oxide such as SiO₂ changes its charged state; by utilizing this both the substrate and the particulates are controlled so as to be negatively charged, and the substrate and the particulates can be pulled apart by the action of electrostatic repulsive force. However, a conventional basic cleaning liquid cannot fully remove metallic impurities on a substrate surface. It is surmised that in a basic region metallic impurities react with hydroxide ion (OH⁻), adsorb on the substrate surface as a hydroxide or a hydroxy complex, and do not dissolve in the liquid.

When the pH of the cleaning liquid is decreased, the removability for metallic impurities improves, but the removability for particulates deteriorates and damage to Cu applied to a substrate surface tends to intensify. On the other hand, when the pH of the cleaning liquid is increased, the removability for particulates improves, but the removability for metallic impurities deteriorates and damage to an SiOC-based low-k material, which is brittle in a basic region, tends to intensify.

In accordance with the present invention, due to the cleaning liquid composition having a pH of 8 to 11, both particulates and metallic impurities can be removed, and cleaning can be carried out without damaging either Cu or a low-k material.

Furthermore, in this pH region, in cleaning after Cu-CMP, a thin Cu₂O layer can be formed on the cleaned Cu surface, and rapid oxidation of the surface when allowed to stand in the air can be suppressed. In an aqueous system, Cu is in a Cu²⁺ or CuO state at a pH in the acidic region, is in a highly activated state, and is rapidly and easily oxidized, but in an alkaline region, it is in a CuO or Cu₂O state (see FIG. 3). Therefore, at a pH in the acidic region, a nonuniform oxidation reaction progresses on the Cu surface after CMP, and a nonuniform oxide film covers the surface, thus increasing the roughness of the surface. On the other hand, at a pH of 8 to 11, a thin Cu₂O layer can be formed; this layer functions as a protective layer for the Cu surface, and rapid oxidation of the Cu surface after CMP can be suppressed, thus enabling cleaning with excellent planarity to be carried out.

The cleaning liquid composition of the present invention does not contain isoascorbic acid, ascorbic acid, or gallic acid. When these compounds are present, not only does the removability for metallic impurities deteriorate, but with isoascorbic acid or ascorbic acid there is also a problem with the stability of the composition due to decomposition.

Furthermore, the cleaning liquid composition of the present invention may contain one or more types of phosphonic acid-based chelating agent in order to improve the removability for metallic impurities and particulates.

The phosphonic acid-based chelating agent is not limited as long as it has a phosphonic acid-derived structure, and examples of the phosphonic acid-based chelating agent include *N,N,N*'*,N*'-ethylenediaminetetrakis(methylenephosphonic acid) (EDTPO), glycine-*N,N*-bis(methylenephosphonic acid) (glyphosine), nitrilotris(methylenephosphonic acid) (NTMP), and salts thereof. These phosphonic acid-based chelating agents have excellent removability for metallic impurities (Fe and Zn in particular) in a pH region of 8 to 11 and have an effect in improving the removability for particulates on the Cu surface after CMP.

Moreover, the cleaning liquid composition of the present invention may contain a surfactant in order to improve the removability for particulates. The type of surfactant is selected as appropriate according to the particulates that are to be removed or the substrate and, although not limited thereto, a water-soluble anionic or nonionic surfactant is preferable. However, care should be taken with the selection since the attack of a nonionic surfactant on a low-k material can increase depending on the number and proportion of ethylene oxides or propylene oxides in the structure.

The cleaning liquid composition of the present invention can be obtained by diluting the starting solution composition of the present invention and, although not limited thereto, the cleaning liquid composition of the present invention can be obtained by diluting the starting solution composition by for example 10 times or greater, preferably by 10 to 1000 times, and more preferably by 50 to 200 times, the number of times being determined as appropriate according to the constitutional composition.

Since the majority of the cleaning liquid composition of the present invention is water, when a production line for an electronic device is equipped with a dilution/mixing apparatus, the starting solution composition can be fed and used by dilution with a water-containing diluent (the diluent including one formed only from ultrapure water) immediately before use, thus advantageously contributing to a reduction in the transport cost, a reduction in carbon dioxide gas when transported, and a reduction in the production cost for electronic device manufacturer.

The cleaning liquid composition of the present invention is for example suitable for a substrate having Cu wiring, and in particular a substrate after chemical mechanical polishing (CMP). On the substrate surface after CMP, in addition to various types of wiring and barrier metal material (Cu, Ti-based compound, Ta-based compound, Ru, etc.) and insulating film material (SiO₂, low-k) on the substrate surface, particulates or metallic impurities contained in a slurry can be present. The particulates are for example mainly of alumina, silica, cerium oxide, etc., and examples of the metallic impurities include Cu that has dissolved in a slurry during polishing and become attached again, Fe derived from an oxidizing agent in the slurry, and a Cu organometallic complex formed by reaction between Cu and a Cu corrosion inhibitor contained in the slurry.

In the present invention, the low-k material is a material having low permittivity used for an interlayer insulating film, etc., and examples thereof include, but are not limited to, porous silicon, a silicon-containing organic polymer, and TEOS (tetraethoxysilane) etc.. Specific examples include Black Diamond (Applied Materials, Inc.) and Aurora (ASM International).

Furthermore, the cleaning liquid composition of the present invention may contain a component other than those described above.

Examples of such a component include an aprotic polar organic solvent such as *N*-methyl-2-pyrrolidinone, *N,N-*dimethylacetamide, or dimethylsulfoxide, a protic organic solvent such as a lower alcohol, an aromatic alcohol, or a glycol, a sugar such as glucose, a sugar alcohol such as D-sorbitol, an inorganic acid such as sulfuric acid or phosphoric acid, a carboxylic acid such as oxalic acid or citric acid, and a sulfonic acid such as methanesulfonic acid, and one or more types of the above may be used in combination.

Then the method for producing a semiconductor substrate in accordance with the present invention is now explained.

The method for producing a semiconductor substrate in accordance with the present invention is a method for producing a semiconductor substrate that includes a step of putting a substrate having Cu wiring in contact with the cleaning liquid composition of the present invention.

Furthermore, the method for producing a semiconductor substrate in accordance with the present invention is a method for producing a semiconductor substrate that includes a step of subjecting the substrate having Cu wiring to chemical mechanical polishing (CMP) prior to the step of putting a substrate having Cu wiring in contact.

Examples of the contacting step include, but are not limited to, a cleaning step after CMP and a cleaning step after processing an insulating film as an upper layer of Cu wiring by means of dry etching. Examples of a contacting method include, but are not limited to, a single wafer cleaning method involving the concomitant use of a brush scrubber, a single wafer cleaning method involving spraying a cleaning liquid by means of a spray or a nozzle, a batch type spray cleaning method, and a batch type immersion cleaning method. Among them, the single wafer cleaning method involving the concomitant use of a brush scrubber and the single wafer cleaning method involving spraying a cleaning liquid by means of a spray or a nozzle are preferable, and the single wafer cleaning method involving the concomitant use of a brush scrubber is particularly preferable.

Examples of the contacting atmosphere include, but are not limited to, air, a nitrogen atmosphere, and a vacuum. Among them, air and a nitrogen atmosphere are preferable.

The contact time is not limited since it is selected as appropriate according to the intended application, but in the case of the single wafer cleaning method involving the concomitant use of a brush scrubber and the single wafer cleaning method involving spraying a cleaning liquid by means of a spray or a nozzle, it is between 0.5 and 5 minutes, and in the case of the batch type spray cleaning method and the batch type immersion cleaning method, it is between 0.5 and 30 minutes.

The temperature is not particularly limited since it is selected as appropriate according to the intended application, but in the case of the single wafer cleaning method involving the concomitant use of a brush scrubber and the single wafer cleaning method involving spraying a cleaning liquid by means of a spray or a nozzle, it is between 20°C and 50°C, and in the case of the batch type spray cleaning method and the batch type immersion cleaning method, it is between 20°C and 100°C.

Examples of the semiconductor substrate include, but are not limited to, silicon, silicon carbide, silicon nitride, gallium arsenide, gallium nitride, gallium phosphide, and indium phosphide etc.. Among them, silicon, silicon carbide, gallium arsenide, and gallium nitride are preferable, and silicon and silicon carbide are particularly preferable.

The contact conditions described above may be combined as appropriate according to the intended application.

Then the method for dissolving a Cu-containing organic residue in accordance with the present invention is now explained.

The method for dissolving a Cu-containing organic residue of the present invention includes a step of putting a Cu-containing organic residue in contact with a cleaning liquid composition comprising one or more types of basic compound and one or more types of nitrogen atom-containing heteromonocyclic aromatic compound as specified in claim 13, having a hydrogen ion concentration (pH) of 8 to 11, wherein the composition does not contain isoascorbic acid, ascorbic acid or gallic acid.

The cleaning liquid composition is not particularly limited as long as it is one described above, but the cleaning liquid composition of the present invention described in detail above may be used.

The contacting method is not particularly limited as long as it is one described above.

### [Examples]

With regard to the cleaning liquid composition of the present invention, the present invention is now explained in further detail by reference to the Examples and Comparative Examples described below, but the present invention should not be construed as being limited thereby.

The concentrations in the Examples and Comparative Examples of the cleaning liquid composition shown in Tables 1 to 6 are the concentrations in the cleaning liquid compositions of each of the Examples and Comparative Examples.

### <Evaluation 1: Organic residue removability>

An 8 inch silicon wafer on the surface of which a film of Cu had been formed by an electroplating method was sectioned into 1.0 × 1.5 cm², immersed in a polyethylene container containing 48 mL of an aqueous solution of BTA (concentration 10 mM, pH 8) at 30°C for 5 minutes without stirring to thus form a Cu-BTA complex layer on the Cu surface, then rinsed with ultrapure water for 1 minute, and dried by blowing with nitrogen. For each of the cleaning liquids the wafer was immersed in a polyethylene container containing 48 mL of the cleaning liquid at 30°C for 5 minutes without stirring, rinsed again with ultrapure water for 1 minute, and dried by blowing with nitrogen. Subsequently, the wafer was immersed in a polyethylene container containing 48 mL of a corrosive aqueous solution (nitrilotriacetic acid 1 mM + triethanolamine 50 mM) at 30°C for 2 minutes without stirring, the wafer was then taken out, and the Cu concentration in the corrosive aqueous solution was analyzed using an ICP-MS (Inductively Coupled Plasma Mass Spectrometer). The higher the Cu concentration in the corrosive aqueous solution, the less the Cu-BTA complex formed as a protective film on the Cu surface, and the higher the organic residue removability of the cleaning liquid used for treatment prior to the corrosive aqueous solution. Table 1 shows the formulations of the cleaning liquid compositions and the results.

### [Table 1]

**Table 1 Evaluation results of Cu-BTA removability for each cleaning liquid**

| | Nitrogen atom-containing heteromonocyclic aromatic compound | | Component other than nitrogen atom-containing heteromonocyclic aromatic compound | | Basic compound | | | | Chelating agent | | pH after adjustment | Cu E.R. (Å/min.) |
|---|---|---|---|---|---|---|---|---|---|---|---|---|
| | Type | Concn. (mmol/L) | Type | Concn. (mmol/L) | Type | Concn. (mmol/L) | Type | Concn. (mmol/L) | Type | Concn. (mmol/L) | | |
| Ex. 1 | Histamine | 10.0 | - | | Choline | | - | | - | | 9.0 | 3.9 |
| Ex. 2 | Histidine | 1.0 | - | | Choline | | - | | - | | 9.0 | 5.2 |
| Ex. 3 | Histamine | 0.2 | - | | Choline | | - | | NTMP | 0.5 | 9.0 | 1.9 |
| Ex. 4 | Histamine | 0.2 | - | | Choline | | - | | NTMP | 0.5 | 10.0 | 3.4 |
| Ex. 5 | Histidine | 0.5 | - | | Choline | | - | | NTMP | 0.5 | 10.5 | 3.5 |
| Ex. 6 | Histidine | 0.5 | - | | Choline | | - | | NTMP | 0.5 | 11.0 | 3.6 |
| Ex. 7 | Histidine | 1.0 | - | | Choline | | TEA | 1.3 | NTMP | 0.2 | 11.0 | 3.6 |
| Ex. 8 | AHP | 5.0 | - | | Choline | | - | | NTMP | 0.5 | 10.0 | 3.6 |
| Ex. 9 | AHP | 5.0 | - | | Choline | *1 | TEA | 1.3 | NTMP | 0.1 | 11.0 | 3.5 |
| Comp. Ex. 1 | - | | - | | Choline | | - | | - | | 9.0 | 0.5 |
| Comp. Ex. 2 | - | | - | | Choline | | - | | - | | 10.0 | 0.5 |
| Comp. Ex. 3 | - | | - | | Choline | | - | | - | | 11.0 | 0.3 |
| Comp. Ex. 4 | - | | - | | Choline | | - | | NTMP | 5.0 | 9.0 | 0.4 |
| Comp. Ex. 5 | - | | - | | Choline | | TEA | 1.3 | NTMP | 0.1 | 10.5 | 0.7 |
| Comp. Ex. 6 | - | | Serine | 5.0 | Choline | | - | | - | | 9.0 | 0.8 |
| Comp. Ex. 7 | - | | Glycylglycine | 1.0 | Choline | | - | | - | | 9.0 | 0.7 |
| Comp. Ex. 8 | - | | Heptogluconic acid | 10.0 | Choline | | - | | - | | 9.0 | 0.4 |
| Comp. Ex. 9 | - | | Ethylenediamine | 1.0 | Choline | | - | | - | | 9.0 | 1.0 |

| | | | | | | | | | | | | |
|---|---|---|---|---|---|---|---|---|---|---|---|---|
| NTMP: nitrilotris(methylenephosphonic acid) AHP: 3-amino-5-hydroxypyrazole TEA: triethanolamine *1: In Examples 1 to 9 and Comparative Examples 1 to 9, added at between 0.5 mmol/L and 50 mmol/L so as to give desired pH. | | | | | | | | | | | | |

### <Evaluation 2: Damage to Cu (etching rate)>

An 8 inch silicon wafer on the surface of which a film of Cu had been formed by an electroplating method was sectioned into 1.5 × 1.5 cm², immersed in an aqueous solution of hydrofluoric acid (0.5 wt%) at 25°C for 1 minute without stirring, rinsed with ultrapure water, dried, and then for each of the cleaning liquids was immersed in a polyethylene container containing 48 mL of the cleaning liquid at 30°C for 2 minutes without stirring, the Cu concentration of the cleaning liquid from which the wafer had been taken out was then measured by means of an ICP-MS, and the Cu etching rate (E.R.) of the cleaning liquid was calculated from the surface area of Cu on the wafer and the Cu concentration of the cleaning liquid. With regard to each of the cleaning liquids, the pH of an aqueous solution of a chelating agent prepared at a predetermined concentration was measured using a pH meter, and was adjusted to a predetermined pH by adding dropwise a basic compound. Table 2 shows the formulations of the cleaning liquid compositions and the results.

### [Table 2]

**Table 2 Evaluation results of damage to Cu (E.R.) by each cleaning liquid**

| | Nitrogen atom-containing heteromonocyclic aromatic compound | | Compound other than nitrogen atom-containing heteromonocyclic aromatic compound | | Basic compound | | | | Chelating agent | | pH after adjustment | Cu E.R. (Å/min.) |
|---|---|---|---|---|---|---|---|---|---|---|---|---|
| | Type | Concn. (mmol/L) | Type | Concn. (mmol/L) | Type | Concn. (mmol/L) | Type | Concn. (mmol/L) | Type | Concn. (mmol/L) | | |
| Ex. 10 | Histamine | 0.2 | - | | Choline | | - | | NTMP | 0.5 | 9.0 | 1.2 |
| Ex. 11 | Histamine | 0.2 | - | | Choline | | - | | NTMP | 0.5 | 10.0 | 1.2 |
| Ex. 12 | Histidine | 0.5 | - | | Choline | | - | | NTMP | 0.5 | 10.5 | 1.5 |
| Ex. 13 | Histidine | 0.5 | - | | Choline | | - | | NTMP | 0.5 | 11.0 | 1.0 |
| Ex. 14 | Histidine | 1.0 | - | | Choline | | TEA | 1.3 | NTMP | 0.1 | 11.0 | 0.7 |
| Ex. 15 | AHP | 5.0 | - | | Choline | | - | | NTMP | 0.5 | 9.0 | 0.9 |
| Ex. 16 | AHP | 5.0 | - | | Choline | | - | | NTMP | 0.5 | 10.0 | 1.2 |
| Ex. 17 | AHP | 5.0 | - | | Choline | | TEA | 1.3 | NTMP | 0.1 | 11.0 | 0.8 |
| Comp. Ex. 10 | - | | - | | TMAH | *2 | - | | Glyphosine | 1.0 | 7.0 | 3.4 |
| Comp. Ex. 11 | - | | - | | MPP | | - | | CyDTA | 1.0 | 7.0 | 8.2 |
| Comp. Ex. 12 | - | | - | | MPP | | - | | CyDTA | 1.0 | 8.1 | 5.4 |
| Comp. Ex. 13 | - | | - | | TMAH | | - | | NTMP | 1.0 | 7.0 | 5.0 |
| Comp. Ex. 14 | - | | Serine | 1.0 | Choline | | - | | - | | 9.0 | 3.5 |
| Comp. Ex. 15 | - | | Nitrilotriacetic acid | 1.0 | Choline | | - | | - | | 9.0 | 3.8 |
| Comp. Ex. 16 | - | | HIDA | 1.0 | Choline | | - | | - | | 9.0 | 4.5 |
| Comp. Ex. 17 | - | | Ethylenediamine | 1.0 | Choline | | - | | - | | 9.0 | 7.6 |

| | | | | | | | | | | | | |
|---|---|---|---|---|---|---|---|---|---|---|---|---|
| TMAH: tetramethylammonium hydroxide NTMP: nitrilotris(methylenephosphonic acid) HIDA: *N*-(2-hydroxyethyl)iminodiacetic acid AHP: 3-amino-5-hydroxypyrazole TEA: triethanolamine CyDTA: trans-1,2-cyclohexanediaminetetraacetic acid MMP: 1-(2-dimethylaminoethyl)-4-methylpiperazine *2: In Ex. 10 to 17 and Comp. Ex. 10 to 17, added at between 0.5 mmol/L and 50 mmol/L so as to give desired pH. | | | | | | | | | | | | |

### <Evaluation 3: Damage to Cu (surface roughness)>

An 8 inch silicon wafer on the surface of which a film of Cu had been formed by an electroplating method was immersed in an aqueous solution of oxalic acid (1 wt%) at 25°C for 1 minute without stirring, rinsed using ultrapure water, dried, then immersed in a cleaning liquid at 25°C for 30 minutes without stirring, then rinsed using ultrapure water, dried, and then subjected to measurement of Cu surface roughness (average surface roughness: Ra) using an AFM (atomic force microscope). Table 3 shows the formulations of the cleaning liquid compositions and the results.

### [Table 3]

**Table 3 Evaluation results of damage to Cu by each cleaning liquid (surface roughness)**

| | Nitrogen atom-containing heteromonocyclic aromatic compound | | Basic compound | | | | Chelating agent | | pH after adjustment | Average surface roughness (Ra) of Cu surface (nm) |
|---|---|---|---|---|---|---|---|---|---|---|
| | Type | Concn. (mmol/L) | Type | Concn. (mmol/L) | Type | Concn. (mmol/L) | Type | Concn. (mmol/L) | | |
| (Before treatment) | | | | | | | | | | 0.70 |
| Ex. 17 | Histidine | 0.5 | Choline | 4.1 | - | | NTMP | 0.5 | 11.0 | 0.78 |
| Ex. 18 | Histidine | 1.0 | Choline | 3.1 | TEA | 1.3 | NTMP | 0.2 | 11.0 | 0.81 |
| Comp. Ex. 17 | - | | TMAH | 25.0 | - | | - | | 12.4 | 1.42 |
| Comp. Ex. 18 | | | | | | | Oxalic acid | 1.2 | 2.0 | 3.51 |

| | | | | | | | | | | |
|---|---|---|---|---|---|---|---|---|---|---|
| NTMP: nitrilotris(methylenephosphonic acid) TEA: triethanolamine | | | | | | | | | | |

### <Evaluation 4: Metallic impurity removability>

A silicon wafer was cleaned using an aqueous ammonia (29 wt%)-aqueous hydrogen peroxide (30 wt%)-water mixed liquid (volume ratio 1:1:6) and then contaminated with calcium (Ca), iron (Fe), nickel (Ni), copper (Cu), and zinc (Zn) at a surface concentration of 10¹² atoms/cm² by a spin coating method. The contaminated wafer was immersed in each cleaning liquid at 25°C for 3 minutes without stirring, the wafer was then taken out, rinsed under running ultrapure water for 3 minutes, dried, and subjected to measurement of the metal concentrations of the wafer surface using a total reflection X-ray fluorescence spectrometer, and the metallic impurity removability was thus evaluated. Table 4 shows the formulations of the cleaning liquid compositions and the results.

### [Table 4]

**Table 4 Evaluation results of metallic impurity removability for each cleaning liquid**

| | Nitrogen atom-containing heteromonocyclic aromatic compound | | Basic compound | | | | Chelating agent | | pH after adjustment | Metal surface Concn. (10¹⁰ atoms/cm²) | | | | |
|---|---|---|---|---|---|---|---|---|---|---|---|---|---|---|
| | Type | Concn. (mmol/L) | Type | Concn. (mmol/L) | Type | Concn. (mmol/L) | Type | Concn. (mmol/L) | | Ca | Fe | Ni | Cu | Zn |
| (Before cleaning) | | | | | | | | | | 180.0 | 160.0 | 170.0 | 160.0 | 160.0 |
| Ex. 19 | Histidine | 0.5 | Choline | | - | | NTMP | 0.5 | 10.0 | D.L. | 0.2 | 0.2 | D.L. | D.L. |
| Ex. 20 | Histidine | 0.5 | Choline | | TEA | 1.3 | NTMP | 0.1 | 10.0 | D.L. | 0.5 | 0.2 | D.L. | D.L. |
| Ex. 21 | Histidine | 0.5 | Choline | | TEA | 1.3 | NTMP | 0.3 | 11.0 | 1.2 | 2.9 | 0.1 | D.L. | 0.7 |
| Ex. 22 | AHP | 5.0 | Choline | | - | | NTMP | 0.5 | 10.0 | D.L. | 1.8 | 0.2 | 1.2 | 1.8 |
| Ex. 23 | Histamine | 0.2 | Choline | *3 | - | | NTMP | 0.5 | 9.0 | 1.8 | 1.0 | 0.7 | D.L. | D.L. |
| Comp. Ex. 19 | - | | Choline | | - | | - | | 10.0 | 24.9 | 59.2 | 38.7 | 46.5 | 33.5 |
| Comp. Ex. 20 | - | | TEA | | - | | - | | 9.9 | 22.9 | 9.4 | 86.2 | 48.2 | 45.4 |
| Comp. Ex. 21 | - | | TMAH | | - | | NTA | 1.0 | 10.0 | 0.2 | 58.8 | 2.0 | 6.7 | 11.7 |
| Comp. Ex. 22 | - | | TMAH | | - | | EDTA | 1.0 | 10.0 | 0.6 | 49.0 | 1.3 | 2.9 | 11.0 |
| Comp. Ex. 23 | - | | TMAH | | - | | Oxalic acid | 11.0 | 9.9 | D.L. | 104.0 | D.L. | 15.4 | 71.5 |

| | | | | | | | | | | | | | | |
|---|---|---|---|---|---|---|---|---|---|---|---|---|---|---|
| NTMP: nitrilotris(methylenephosphonic acid) AHP: 3-amino-5-hydroxypyrazole TEA: triethanolamine TMAH: tetramethylammonium hydroxide NTA: nitrilotriacetic acid EDTA: ethylenediaminetetraacetic acid D.L.: Equal to or less than detection limit (less than 10⁹atoms/cm²) *3: In Ex. 19 to 23 and Comp. Ex. 19 to 23, added at between 0.5 mmol/L and 50 mmol/L so as to give desired pH. | | | | | | | | | | | | | | |

### <Evaluation 5: particulate removability>

An 8 inch silicon wafer on the surface of which a film of Cu had been formed by an electroplating method was polished using a CMP device and a CMP slurry (silica slurry (ø35 nm)) for 30 seconds. Subsequently, for each of the cleaning liquids it was subjected in a cleaning device to brush scrubber cleaning at room temperature using each cleaning liquid for 30 seconds, a rinsing treatment using ultrapure water for 30 seconds, and spin drying. The cleaned wafer was subjected to counting of the number of particulates on the surface using a surface profiler, and the particulate removability was thus evaluated. Table 5 shows the formulations of the cleaning liquid compositions and the results.

### [Table 5]

**Table 5 Evaluation results of particulate removability for each cleaning liquid**

| | Nitrogen atom-containing heteromonocyclic aromatic compound | | Basic compound | | | | Chelating agent | | pH after adjustment | Number of particulates after cleaning |
|---|---|---|---|---|---|---|---|---|---|---|
| | Type | Concn. (mmol/L) | Type | Concn. (mmol/L) | Type | Concn. (mmol/L) | Type | Concn. (mmol/L) | | (Counts/8 inch wafer, ø0.3µm ↑ |
| Ex. 24 | Histidine | 0.5 | Choline | | - | | NTMP | 0.7 | 11.0 | 150 |
| Ex. 25 | Histidine | 1.0 | Choline | | TEA | 1.3 | NTMP | 0.2 | 11.0 | 161 |
| Ex. 26 | Histidine | 1.0 | Choline | | TEA | 1.3 | NTMP | 0.1 | 11.0 | 249 |
| Ex. 27 | Histidine | 0.5 | Choline | | - | | NTMP | 0.5 | 10.0 | 233 |
| Ex. 28 | Histidine | 0.5 | Choline | *4 | - | | NTMP | 0.5 | 9.0 | 417 |
| Comp. Ex. 24 | - | | Choline | | - | | - | | 11.4 | 5082 |
| Comp. Ex. 25 | - | | TEA | | - | | - | | 9.6 | 3478 |
| Comp. Ex. 26 | - | | TMAH | | - | | Ascorbic acid | 5.5 | 11.9 | 6174 |
| Comp. Ex. 27 | - | | TEA | | - | | Oxalic acid | 2.0 | 9.4 | 2134 |
| Comp. Ex. 28 | - | | TEA | | - | | CyDTA | 0.1 | 9.0 | 8804 |

| | | | | | | | | | | |
|---|---|---|---|---|---|---|---|---|---|---|
| Compound A: nitrogen atom-containing heteromonocyclic aromatic compound Compound B: basic compound NTMP: nitrilotris(methylenephosphonic acid) TEA: triethanolamine TMAH: tetramethylammonium hydroxide CyDTA: trans-1,2-cyclohexanediaminetetraacetic acid ø0.3µm ↑ : indicates that particle size of particulate is 0.3 µm or greater. *4: In Ex. 24 to 28 and Comp. Ex. 24 to 28, added at between 0.5 mmol/L and 50 mmol/L so as to give desired pH. | | | | | | | | | | |

### <Evaluation 6: Damage to low-k material>

For each of the cleaning liquids a silicon wafer on which a film of a CVD type SiOC-based low permittivity (low-k) material (permittivity: 2.4) had been formed was immersed in the cleaning liquid at 25°C for 3 minutes and 30 minutes without stirring, rinsed using ultrapure water, dried, and then subjected to measurement of the infrared absorption (IR) spectrum using an FT-IR (Fourier transform IR absorption spectrometer), and the Si-O bond absorption at around 1150 cm⁻¹ was compared.

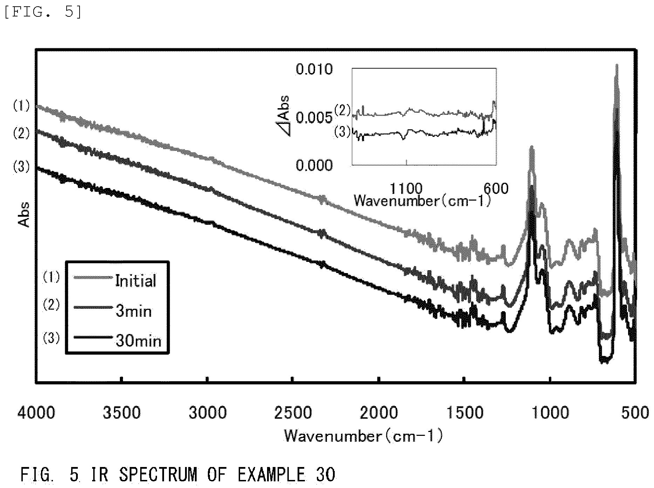

Table 6 shows the formulations of the cleaning liquid compositions and the evaluation results. Furthermore, an IR spectrum of Example 29 (FIG. 4) and an IR spectrum of Example 30 (FIG. 5) are shown. In FIG. 4 and FIG. 5, since no change in the spectrum around 1150 cm⁻¹, which shows Si-O bonding, was observed it can be seen that there was no damage to the low-k material.

### [Table 6]

**Table 6 Evaluation results of damage to low-k material by each cleaning liquid (Change in IR spectrum)**

| | Nitrogen atom-containing heteromonocyclic aromatic compound | | Basic compound | | | | Chelating agent | | pH after adjustment | Change in spectrum in vicinity of 1150 cm⁻¹ |
|---|---|---|---|---|---|---|---|---|---|---|
| | Type | Concn. (mmol/L) | Type | Concn. (mmol/L) | Type | Concn. (mmol/L) | Type | Concn. (mmol/L) | | |
| Ex. 29 | Histidine | 0.5 | Choline | 4.1 | - | 1.3 | NTMP | 0.5 | 11.0 | None |
| Ex. 30 | Histidine | 1.0 | Choline | 3.1 | TEA | 1.3 | NTMP | 0.2 | 11.0 | None |

| | | | | | | | | | | |
|---|---|---|---|---|---|---|---|---|---|---|
| NTMP: nitrilotris(methylenephosphonic acid) TEA: triethanolamine | | | | | | | | | | |

## Claims

1. A cleaning liquid composition for cleaning a substrate having Cu wiring, the cleaning liquid composition comprising one or more types of basic compound and one or more types of nitrogen atom-containing heteromonocyclic aromatic compound, wherein the one or more nitrogen atom-containing heteromonocyclic aromatic compound is selected from 1H-pyrrole, minaline, 1H-pyrazole, 1H-pyrazole-4-carboxylic acid, 1-methyl-1H-pyrazole-5-carboxylic acid, 5-methyl-1H-pyrazole-3-carboxylic acid, 3,5-pyrazole dicarboxylic acid, 3-amino-5-hydroxypyrazole, histidine, histamine, 3-amino-1,2,4-triazole, 4-amino-1,2,4-triazole, 3,5-diamino-1,2,4-triazole,
pyridine, 2-pyridone, 4-pyridone, picoline, α-collidine, β-collidine, γ-collidine, picolinic acid, picolinamide, nicotinic acid, nicotinamide, isonicotinic acid, citrazinic acid, quinolinic acid, lutidinic acid, isocinchomeronic acid, dipicolinic acid, cinchomeronic acid, dinicotinic acid, berberonic acid, fusaric acid, ethionamide, nicotine, cotinine, anabasine, anatabine, homarine, trigonelline, picolinuric acid, nicotinuric acid, risedronic acid, dihydroxypyridine, pyrazine, pyrazinoic acid, pyrazinamide, pyrimidine, cytosine, uracil, thymine, orotic acid, dialuric acid, uramil, isouramil, thiamine, pyridazine, maleic acid hydrazide, melamine, and cyanuric acid and having a hydrogen ion concentration (pH) of 8 to 11, wherein the composition does not contain isoascorbic acid, ascorbic acid or gallic acid.

2. The cleaning liquid composition according to Claim 1, wherein the substrate having Cu wiring is a substrate obtained after chemical mechanical polishing (CMP).

3. The cleaning liquid composition according to Claim 1 or 2, wherein the nitrogen atom-containing heteromonocyclic aromatic compound is a five-membered ring compound.

4. The cleaning liquid composition according to any one of Claims 1 to 3, wherein the basic compound is a quaternary ammonium compound or a straight chain aliphatic amine.

5. The cleaning liquid composition according to any one of Claims 1 to 4, wherein the basic compound is a quaternary ammonium
compound other than tetramethylammonium hydroxide, or an alkanolamine.

6. The cleaning liquid composition according to any one of Claims 1 to 5, wherein it further comprises one or more types of phosphonic acid-based chelating agent.

7. The cleaning liquid composition according to Claim 6, wherein the phosphonic acid-based chelating agent is one or more types selected from the group consisting of *N,N,N',N'-*ethylenediaminetetrakis(methylenephosphonic acid) (EDTPO), glycine-*N,N*-bis(methylenephosphonic acid) (glyphosine), nitrilotris(methylenephosphonic acid) (NTMP), and salts thereof.

8. The cleaning liquid composition according to any one of Claims 1 to 7, wherein it further comprises one or more types of anionic or nonionic surfactant.

9. A starting solution composition for the cleaning liquid composition according to any one of Claims 1 to 8, the starting solution composition being for use in obtaining the cleaning liquid composition by dilution at 10 times to 1000 times.

10. A method for producing a semiconductor substrate, comprising a step of putting a substrate having Cu wiring in contact with the cleaning liquid composition according to any one of Claims 1 to 8.

11. The method for producing a semiconductor substrate according to Claim 10, wherein it comprises a step of subjecting the substrate having Cu wiring to chemical mechanical polishing (CMP) prior to the step of putting a substrate having Cu wiring in contact.

12. The method for producing a semiconductor substrate according to Claim 10 or 11, wherein the step of putting a substrate having Cu wiring in contact is a step of cleaning the substrate having Cu wiring.

13. A method for dissolving a Cu-containing organic residue, the method comprising a step of putting a Cu-containing organic residue in contact with a cleaning liquid composition comprising one or more types of basic compound and one or more types of nitrogen atom-containing heteromonocyclic aromatic compound, wherein the one or more nitrogen atom-containing heteromonocyclic aromatic compound is selected from 1H-pyrrole, minaline, 1H-pyrazole, 1H-pyrazole-4-carboxylic acid, 1-methyl-1H-pyrazole-5-carboxylic acid, 5-methyl-1H-pyrazole-3-carboxylic acid, 3,5-pyrazole dicarboxylic acid, 3-amino-5-hydroxypyrazole, histidine, histamine, 3-amino-1,2,4-triazole, 4-amino-1,2,4-triazole, 3,5-diamino-1,2,4-triazole, pyridine, 2-pyridone, 4-pyridone, picoline, α-collidine, β-collidine, γ-collidine, picolinic acid, picolinamide, nicotinic acid, nicotinamide, isonicotinic acid, citrazinic acid, quinolinic acid, lutidinic acid, isocinchomeronic acid, dipicolinic acid, cinchomeronic acid, dinicotinic acid, berberonic acid, fusaric acid, ethionamide, nicotine, cotinine, anabasine, anatabine, homarine, trigonelline, picolinuric acid, nicotinuric acid, risedronic acid, dihydroxypyridine, pyrazine, pyrazinoic acid, pyrazinamide, pyrimidine, cytosine, uracil, thymine, orotic acid, dialuric acid, uramil, isouramil, thiamine, pyridazine, maleic acid hydrazide, melamine, and cyanuric acid and having a hydrogen ion concentration (pH) of 8 to 11, wherein the composition does not contain isoascorbic acid, ascorbic acid or gallic acid.

14. The method according to Claim 13, wherein the Cu-containing organic residue comprises a Cu-benzotriazole (BTA) complex.

## Patentansprüche

1. Reinigungsflüssigkeitszusammensetzung zum Reinigen eines Substrats mit Cu-Verdrahtung, wobei die Reinigungsflüssigkeitszusammensetzung eine oder mehrere Arten einer basischen Verbindung und eine oder mehrere Arten einer stickstoffatomhaltigen heteromonocyclischen aromatischen Verbindung umfasst, wobei die eine oder die mehreren stickstoffatomhaltige(n) heteromonocyclische(n) aromatische(n) Verbindung(en) ausgewählt ist/sind aus 1H-Pyrrol, Minalin, 1H-Pyrazol, 1H-Pyrazol-4-carbonsäure, 1-Methyl-1H-pyrazol-5-carbonsäure, 5-Methyl-1H-pyrazol-3-carbonsäure, 3,5-Pyrazoldicarbonsäure, 3-Amino-5-hydroxypyrazol, Histidin, Histamin, 3-Amino-1,2,4-triazol, 4-Amino-1,2,4-triazol, 3,5-Diamino-1,2,4-triazol, Pyridin, 2-Pyridon, 4-Pyridon, Picolin, α-Collidin, β-Collidin, γ-Collidin, Picolinsäure, Picolinamid, Nicotinsäure, Nicotinamid, Isonicotinsäure, Citrazinsäure, Chinolinsäure, Lutidinsäure, Isocinchomeronsäure, Dipicolinsäure, Cinchomeronsäure, Dinicotinsäure, Berberonsäure, Fusarsäure, Ethionamid, Nicotin, Cotinin, Anabasin, Anatabin, Homarin, Trigonellin, Picolinursäure, Nicotinursäure, Risedronsäure, Dihydroxypyridin, Pyrazin, Pyrazincarbonsäure, Pyrazinamid, Pyrimidin, Cytosin, Uracil, Thymin, Orotsäure, Dialursäure, Uramil, Isouramil, Thiamin, Pyridazin, Maleinsäurehydrazid, Melamin und Cyanursäure, und eine Wasserstoffionenkonzentration (pH) von 8 bis 11 aufweist, wobei die Zusammensetzung keine Isoascorbinsäure, Ascorbinsäure oder Gallussäure enthält.

2. Reinigungsflüssigkeitszusammensetzung nach Anspruch 1, wobei das Substrat mit Cu-Verdrahtung ein Substrat ist, das nach einem chemisch-mechanischen Polieren (CMP) erhalten wurde.

3. Reinigungsflüssigkeitszusammensetzung nach Anspruch 1 oder 2, wobei die stickstoffatomhaltige heteromonocyclische aromatische Verbindung eine fünfgliedrige Ringverbindung ist.

4. Reinigungsflüssigkeitszusammensetzung nach einem der Ansprüche 1 bis 3, wobei die basische Verbindung eine quaternäre Ammoniumverbindung oder ein geradkettiges aliphatisches Amin ist.

5. Reinigungsflüssigkeitszusammensetzung nach einem der Ansprüche 1 bis 4, wobei die basische Verbindung eine andere quaternäre Ammoniumverbindung als Tetramethylammoniumhydroxid oder ein Alkanolamin ist.

6. Reinigungsflüssigkeitszusammensetzung nach einem der Ansprüche 1 bis 5, wobei diese ferner eine oder mehrere Arten eines Chelatbildners auf Phosphonsäurebasis umfasst.

7. Reinigungsflüssigkeitszusammensetzung nach Anspruch 6, wobei es sich beim Chelatbildner auf Phosphonsäurebasis um eine oder mehrere Arten, ausgewählt aus der Gruppe bestehend aus *N,N,N',N'*-Ethylendiamintetrakis-(methylenphosphonsäure) (EDTPO), Glycin-*N,N*-bis(methylenphosphonsäure) (Glyphosin), Nitrilotris(methylenphosphonsäure) (NTMP) und Salzen davon, handelt.

8. Reinigungsflüssigkeitszusammensetzung nach einem der Ansprüche 1 bis 7, wobei diese ferner eine oder mehrere Arten eines anionischen oder nichtionischen Tensids umfasst.

9. Ausgangslösungszusammensetzung für die Reinigungsflüssigkeitszusammensetzung nach einem der Ansprüche 1 bis 8, wobei die Ausgangslösungszusammensetzung zur Verwendung bei der Gewinnung der Reinigungsflüssigkeitszusammensetzung durch 10-fache bis 1.000-fache Verdünnung bestimmt ist.

10. Verfahren zur Herstellung eines Halbleitersubstrats, das einen Schritt des Inkontaktbringens eines Substrats mit Cu-Verdrahtung mit der Reinigungsflüssigkeitszusammensetzung nach einem der Ansprüche 1 bis 8 umfasst.

11. Verfahren zur Herstellung eines Halbleitersubstrats nach Anspruch 10, wobei dieses einen Schritt umfasst, bei dem vor dem Schritt des Inkontaktbringens eines Substrats mit Cu-Verdrahtung das Substrat mit Cu-Verdrahtung einem chemisch-mechanischen Polieren (CMP) unterzogen wird.

12. Verfahren zur Herstellung eines Halbleitersubstrats nach Anspruch 10 oder 11, wobei der Schritt des Inkontaktbringens eines Substrats mit Cu-Verdrahtung ein Schritt zum Reinigen des Substrats mit Cu-Verdrahtung ist.

13. Verfahren zum Lösen eines Cu-haltigen organischen Rückstands, wobei das Verfahren einen Schritt des Inkontaktbringens eines Cu-haltigen organischen Rückstands mit einer Reinigungsflüssigkeitszusammensetzung umfasst, die eine oder mehrere Arten einer basischen Verbindung und eine oder mehrere Arten einer stickstoffatomhaltigen heteromonocyclischen aromatischen Verbindung umfasst, wobei die eine oder die mehreren stickstoffatomhaltige(n) heteromonocyclische(n) aromatische(n) Verbindung(en) ausgewählt ist/sind aus 1H-Pyrrol, Minalin, 1H-Pyrazol, 1H-Pyrazol-4-carbonsäure, 1-Methyl-1H-pyrazol-5-carbonsäure, 5-Methyl-1H-pyrazol-3-carbonsäure, 3,5-Pyrazoldicarbonsäure, 3-Amino-5-hydroxypyrazol, Histidin, Histamin, 3-Amino-1,2,4-triazol, 4-Amino-1,2,4-triazol, 3,5-Diamino-1,2,4-triazol, Pyridin, 2-Pyridon, 4-Pyridon, Picolin, α-Collidin, β-Collidin, γ-Collidin, Picolinsäure, Picolinamid, Nicotinsäure, Nicotinamid, Isonicotinsäure, Citrazinsäure, Chinolinsäure, Lutidinsäure, Isocinchomeronsäure, Dipicolinsäure, Cinchomeronsäure, Dinicotinsäure, Berberonsäure, Fusarsäure, Ethionamid, Nicotin, Cotinin, Anabasin, Anatabin, Homarin, Trigonellin, Picolinursäure, Nicotinursäure, Risedronsäure, Dihydroxypyridin, Pyrazin, Pyrazincarbonsäure, Pyrazinamid, Pyrimidin, Cytosin, Uracil, Thymin, Orotsäure, Dialursäure, Uramil, Isouramil, Thiamin, Pyridazin, Maleinsäurehydrazid, Melamin und Cyanursäure, und eine Wasserstoffionenkonzentration (pH) von 8 bis 11 aufweist, wobei die Zusammensetzung keine Isoascorbinsäure, Ascorbinsäure oder Gallussäure enthält.

14. Verfahren nach Anspruch 13, wobei der Cu-haltige organische Rückstand einen Cu-Benzotriazol(BTA)-Komplex umfasst.

## Revendications

1. Composition liquide de nettoyage destiné à nettoyer un substrat ayant un câblage en Cu, la composition liquide de nettoyage comprenant un ou plusieurs types de composé basique et un ou plusieurs types de composé aromatique hétéromonocyclique contenant un atome d'azote, dans laquelle les uns ou plusieurs composés aromatiques hétéromonocycliques contenant un atome d'azote sont choisis parmi le 1H-pyrrole, la minaline, le 1H-pyrazole, l'acide 1H-pyrazole-4-carboxylique, l'acide 1-méthyl-1H-pyrazole-5-carboxylique, l'acide 5-méthyl-1H-pyrazole-3-carboxylique, l'acide 3,5-pyrazole dicarboxylique, le 3-amino-5-hydroxypyrazole, l'histidine, l'histamine, le 3-amino-1,2,4-triazole, le 4-amino-1,2,4-triazole, le 3,5-diamino-1,2,4-triazole, la pyridine, la 2-pyridone, la 4-pyridone, la picoline, l'α-collidine, la β-collidine, γ-collidine, l'acide picolinique, le picolinamide, l'acide nicotinique, le nicotinamide, l'acide isonicotinique, l'acide citrazinique, l'acide quinoléinique, l'acide lutidinique, l'acide isocinchoméronique, l'acide dipicolinique, l'acide cinchoméronique, l'acide dinicotinique, l'acide berbéronique, l'acide fusarique, l'éthionamide, la nicotine, la cotinine, l'anabasine, l'anatabine, l'homarine, la trigonelline, l'acide picolinurique, l'acide nicotinurique, l'acide risédronique, la dihydroxypyridine, la pyrazine, l'acide pyrazinoïque, le pyrazinamide, la pyrimidine, la cytosine, l'uracile, la thymine, l'acide orotique, l'acide dialurique, l'uramile, l'isouramile, la thiamine, la pyridazine, l'hydrazide de l'acide maléique, la mélamine, et l'acide cyanurique et ayant une concentration en ion hydrogène (pH) de 8 à 11, dans lequel la composition ne contient pas d'acide isoascorbique, d'acide ascorbique ou d'acide gallique.

2. Composition liquide de nettoyage selon la revendication 1, dans laquelle le substrat ayant un câblage en Cu est un substrat obtenu après polissage chimique-mécanique (CMP).

3. Composition liquide de nettoyage selon la revendication 1 ou 2, dans laquelle le composé aromatique hétéromonocyclique contenant un atome d'azote est un composé de cycle à cinq chaînons.

4. Composition liquide de nettoyage selon l'une quelconque des revendications 1 à 3, dans laquelle le composé basique est un composé d'ammonium quaternaire ou une amine aliphatique à chaîne droite.

5. Composition liquide de nettoyage selon l'une quelconque des revendications 1 à 4, dans lequel le composé basique est un composé ammonium quaternaire autre que l'hydroxyde de tétraméthylammonium, ou une alcanolamine.

6. Composition liquide de nettoyage selon l'une quelconque des revendications 1 à 5, dans laquelle elle comprend en outre un ou plusieurs types d'agent chélatant à base d'acide phosphonique.

7. Composition liquide de nettoyage selon la revendication 6, dans laquelle l'agent chélatant à base d'acide phosphonique est un ou plusieurs types choisis dans le groupe consistant en le *N,N,N',N'-*éthylènediaminetétrakis (acide méthylènephosphonique) (EDTPO), le glycine-*N,N*-bis (acide méthylène phosphonique) (glyphosine), le nitrilotris (acide méthylène phosphonique) (NTMP) et leurs sels.

8. Composition liquide de nettoyage selon l'une quelconque des revendications 1 à 7, dans laquelle elle comprend en outre un ou plusieurs types de tensioactifs anioniques ou non ioniques.

9. Composition de solution de départ pour la composition liquide de nettoyage selon l'une quelconque des revendications 1 à 8, la composition de solution de départ étant utilisée pour obtenir la composition liquide de nettoyage par une dilution de 10 fois à 1 000 fois.

10. Procédé de production d'un substrat semiconducteur, comprenant une étape consistant à placer un substrat ayant un câblage en Cu en contact avec la composition liquide de nettoyage selon l'une quelconque des revendications 1 à 8.

11. Procédé de production d'un substrat semiconducteur selon la revendication 10, dans lequel il comprend une étape de soumission du substrat ayant un câblage en Cu à un polissage chimique-mécanique (CMP) avant l'étape consistant à placer en contact un substrat ayant un câblage en Cu.

12. Procédé de production d'un substrat semiconducteur selon la revendication 10 ou 11, dans lequel l'étape consistant à placer en contact un substrat ayant un câblage en Cu est une étape de nettoyage du substrat ayant un câblage en Cu.

13. Procédé de dissolution d'un résidu organique contenant du Cu, le procédé comprenant une étape consistant à placer un résidu organique contenant du Cu en contact avec une composition liquide de nettoyage comprenant un ou plusieurs types de composé basique et un ou plusieurs types de composé aromatique hétéromonocyclique contenant un atome d'azote, dans lequel les uns ou plusieurs composés aromatiques hétéromonocyliques contenant un atome d'azote sont choisis parmi le 1H-pyrrole, la minaline, le 1H-pyrazole, l'acide 1H-pyrazole-4-carboxylique, l'acide 1-méthyl-1H-pyrazole-5-carboxylique, l'acide 5-méthyl-1H-pyrazole-3-carboxylique, l'acide 3,5-pyrazole dicarboxylique, le 3-amino-5-hydroxypyrazole, l'histidine, l'histamine, le 3-amino-1,2,4-triazole, le 4-amino-1,2,4-triazole, le 3,5-diamino-1,2,4-triazole, la pyridine, la 2-pyridone, la 4-pyridone, la picoline, l'α-collidine, la β-collidine, γ-collidine, l'acide picolinique, le picolinamide, l'acide nicotinique, le nicotinamide, l'acide isonicotinique, l'acide citrazinique, l'acide quinoléinique, l'acide lutidinique, l'acide isocinchoméronique, l'acide dipicolinique, l'acide cinchoméronique, l'acide dinicotinique, l'acide berbéronique, l'acide fusarique, l'éthionamide, la nicotine, la cotinine, l'anabasine, l'anatabine, l'homarine, la trigonelline, l'acide picolinurique, l'acide nicotinurique, l'acide risédronique, la dihydroxypyridine, la pyrazine, l'acide pyrazinoïque, le pyrazinamide, la pyrimidine, la cytosine, l'uracile, la thymine, l'acide orotique, l'acide dialurique, l'uramile, l'isouramile, la thiamine, la pyridazine, l'hydrazide de l'acide maléique, la mélamine, et l'acide cyanurique et ayant une concentration en ion hydrogène (pH) de 8 à 11, dans lequel la composition ne contient pas d'acide isoascorbique, d'acide ascorbique ou d'acide gallique.

14. Procédé selon la revendication 13, dans lequel le résidu organique contenant du Cu comprend un complexe Cu-benzotriazole (BTA).
